# EUROPÄISCHE PATENTSCHRIFT

(11) **EP 0 787 306 B1**
(45) Veröffentlichungstag und Bekanntmachung des Hinweises auf die Patenterteilung: **05.07.2006**
(21) Anmeldenummer: 95934095.1
(22) Anmeldetag: 22.09.1995
(51) Int. Cl.: G01R 31/36

(54) **VERFAHREN ZUR BESTIMMUNG DES LADEZUSTANDES EINES AKKUMULATORS**
PROCESS FOR DETERMINING THE STATE OF CHARGE OF AN ACCUMULATOR
PROCEDE PERMETTANT DE DETERMINER L'ETAT DE CHARGE D'UN ACCUMULATEUR

(30) Priorität: 21.10.1994 DE 4437647
(43) Veröffentlichungstag der Anmeldung: 06.08.1997
(73) Patentinhaber: Braun GmbH, Kronberg (DE)
(72) Erfinder: BERGK, Günther, D-65527 Niedernhausen (DE); CIMBAL, Jochen, D-61169 Friedberg (DE)
(86) Internationale Anmeldenummer: PCT/EP1995/003736
(87) Internationale Veröffentlichungsnummer: WO 1996/012970

(56) Entgegenhaltungen:
- EP-A- 0 248 461
- EP-A- 0 359 237
- EP-A- 0 425 044
- EP-A- 0 600 234
- DE-A- 4 131 981

## Beschreibung

Die vorliegende Erfindung betrifft Verfahren zur Bestimmung des Ladezustands eines Akkumulators. Mit dem Begriff Akkumulator ist ein Ladungsspeicher gemeint, der auch aus mehreren Zellen bestehen kann.

Ein Verfahren zur Bestimmung des Ladezustands von Akkumulatoren sowie eine Vorrichtung zur Durchführung des Verfahrens sind bereits aus der DE 41 31 981 A1 bekannt, die nachfolgend anhand der Figuren 1 bis 4 beschrieben werden.

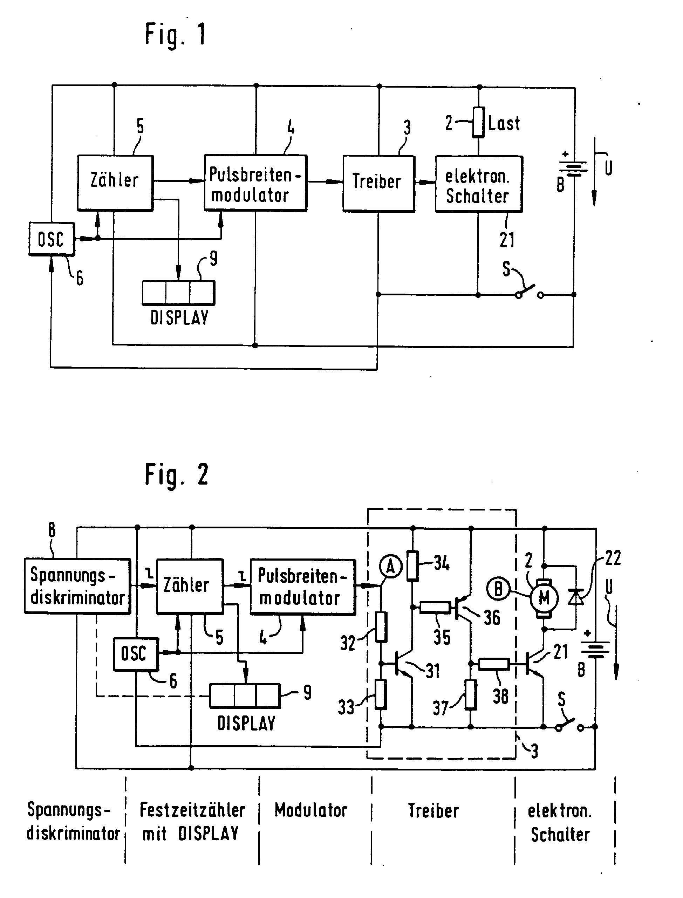

Fig. 1 zeigt eine Last (einen Verbraucher) 2, die über einen Ein-/Ausschalter S und über einen elektronischen Schalter 21 an einen Akkumulator B geschaltet werden kann. Der Akkumulator B kann über eine nicht dargestellte Ladeschaltung aufgeladen werden. Der elektronische Schalter 21 wird über eine Treiberschaltung 3 von einem Pulsbreitenmodulator 4 angesteuert.

Ein Zähler 5 registriert die Anschlußzeit der einen im wesentlichen konstanten Stromverbrauch aufweisenden Last 2 über den Schalter S an den Akkumulator B ab vollgeladenem Akkumulator.

Da auch die Nennkapazität des Akkumulators B bekannt ist, wird ein den Ladezustand des Akkumulators anzeigendes Display 9 auf Zeitbasis vom Zähler 5 gesteuert. Wenn eine vorgegebene Anschlußzeit vergangen ist, die auf Grund des bekannten Stromverbrauchs und der bekannten Nennkapazität des Akkumulators B derart bestimmt wird, daß der Akkumulator dann nur noch wenig Ladung enthält, gibt der Zähler 5 ein Ausgangssignal ab. Zu diesem Zeitpunkt zeigt das Display 9 den Ladezustand "Null" an Dieses Signal bewirkt, daß der elektronische Schalter 21 angesteuert wird. Diese Ansteuerung kann über den Pulsbreitenmodulator 4 erfolgen, der das Tastverhältnis der Steuerspannung allmählich bis auf Null reduziert und so den durch die Last 2 fließenden Strom allmählich verkleinert. Ein Oszillator 6 stellt Taktimpulse für den Zähler 5 und den Pulsbreitenmodulator 4 bereit.

In Fig. 2 ist der Verbraucher (die Last) 2 ein Gleichstrommotor M, beispielsweise eines elektrischen Rasierapparats. Die Serienschaltung des Motors M mit dem Schalttransistor 21 wird über den Ein-/Ausschalter S bei Inbetriebnahme an den Akkumulator B geiegt. Eine zum Motor M parallelgeschaltete Diode 22 verhindert induktive Spannungsspitzen. Die Basis des Schalttransistors 21 wird über die aus den Transistoren 31, 36 und den Widerständen 32, 33, 34, 35, 37, 38 bestehende Treiberschaltung 3 vom Ausgang des Pulsbreitenmodulators 4 angesteuert.

Dem Akkumulator B ist ein Spannungsdiskriminator 8 und der Zähler 5 direkt parallelgeschaltet, das heißt nicht über den Ein-/Ausschalter S. Der Spannungsdiskriminator 8 detektiert eine bestimmte Spannung U am Akkumulator B. Diese detektierte Spannung U entspricht dabei einer Klemmenspannung des Akkumulators, der ein Ladezustand des Akkumulators entsprechend einer Restladung des Akkumulators von 10% bis 20% zugeordnet wird ("low charge" Punkt). Bis zum Erreichen dieses low charge Punkts zeigt das Display 9 den auf Grund der vergangenen Anschlußzeit des Motors M an den Akkumulator B ermittelten Ladezustand an.

Hat der Spannungsdiskriminator 8 den low charge Punkt der Spannung U am Akkumulator B detektiert, wird der Zähler 5 und eine zweite Anzeigeeinheit des Displays 9 gestartet. Wenn der detektierte low charge Punkt erreicht ist, kann der Motor beispielsweise nur noch 8 Minuten bis zur vollständigen Entladung des Akkumulators B betrieben werden. Die für den Zähler 5 vorgegebene Zeit beträgt nun beispielsweise 6 Minuten, um eine vollständige Entladung des Akkumulators mit Sicherheit zu verhindern. Diese 6 Minuten können in sechs feste, gleichgroße Zeitintervalle unterteilt werden, so daß jede Minute ein Segment der zweiten Anzeigeeinheit des Displays 9 angesteuert wird. Diese Segmente können auch die noch verbleibenden Minuten bis zum Ablauf der vorgegebenen Zeit anzeigen. Nach Ablauf der vorgegebenen Zeit (6 Minuten), das heißt wenn der Zähler 5 auf Null angelangt ist, wird der Pulsbreitenmodulator 4 angesteuert.

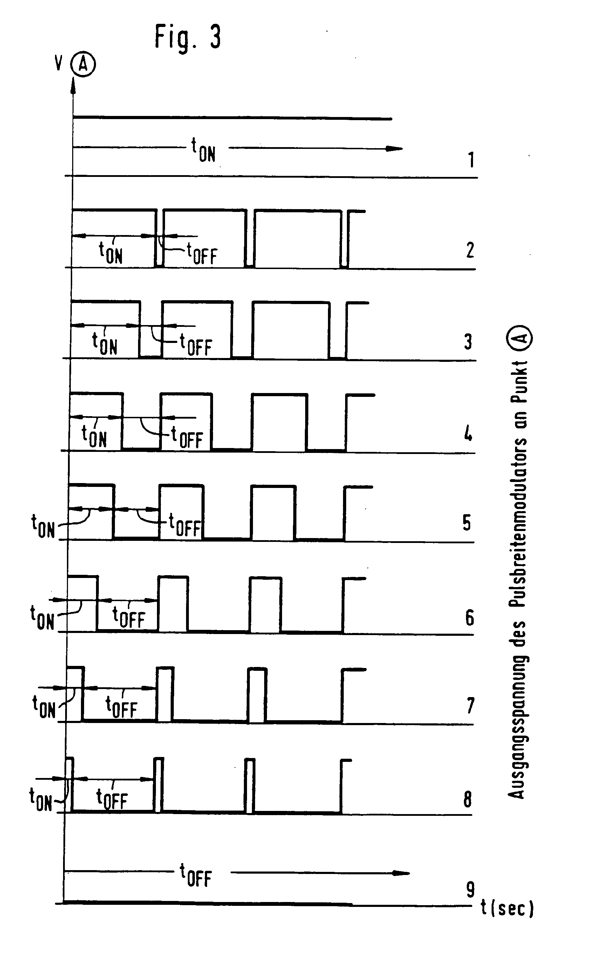

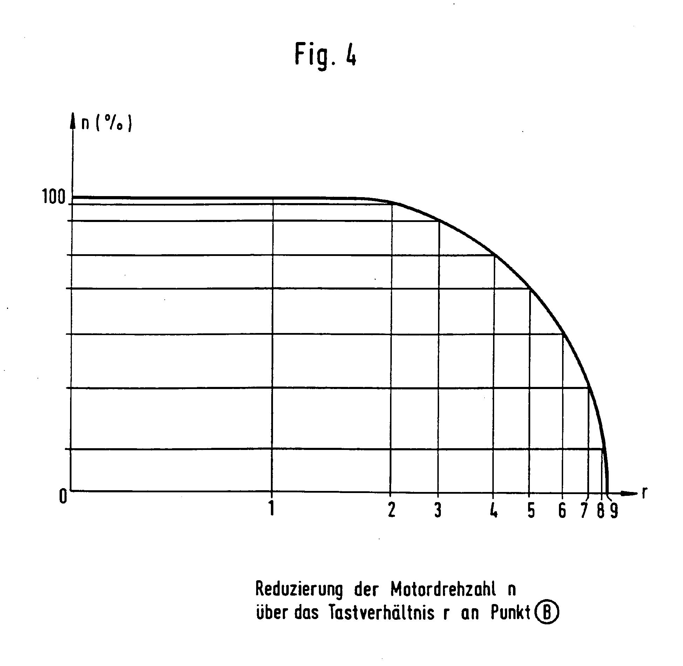

Dieser Pulsbreitenmodulator 4 reduziert das Tastverhältnis der dem Treiber 3 zugeführten Steuerspannung auf eine beispielsweise in Fig. 3 dargestellte Weise. Die verschiedenen Tastverhältnisse in Fig. 3 sind mit Ziffern von 1 (volle Steuerspannung) bis 9 (Steuerspannung Null) versehen. In Fig. 4 ist nun die Motordrehzahl (in % der Nenndrehzahl) in Abhängigkeit dieser Tastverhältnisse dargestellt, wobei die mit den Ziffern 1 bis 9 angegebenen Tastverhältnisse denen in Fig. 3 entsprechen. Diese Kurve entspricht im wesentlichen dem Verlauf der Spannung eines Akkumulators bei angeschaltetem Verbraucher bis zur vollständigen Entladung.

Auf diese Weise wird eine Tiefentladung des Akkumulators verhindert. Infolge des nicht abrupten Stillstands des Motors wird verhindert, daß bei einem Rasierapparat oder einer Haarschneidemaschine unvorhergesehen Haare schmerzhaft eingeklemmt werden. Abweichend von der hier beschriebenen digitalen Schaltung zur Realisierung dieser Wirkung ist es ebenfalls möglich, diese Wirkung durch eine analoge Schaltung zu realisieren.

Zusammenfassend lehrt also die DE 41 31 981 A1, die Betriebszeit eines elektrischen Geräts, insbesondere eines Rasierapparats oder einer Haarschneidemaschine, von einem Zähler zu registrieren. Entsprechend der Betriebszeit werden Segmente eines Displays angesteuert, so daß dem Benutzer der momentane Ladungszustand der Akkumulatoren bzw. des Akkumulators angezeigt wird. Bei einer ersten Variante erfolgt die Anzeige des Ladezustands lediglich anhand der durch den Zähler gemessenen Zeit, während der das Gerät an die Batterie angeschlossen war. Diese Anzeige liefert nur dann genaue Werte, wenn der Stromverbrauch des Geräts und die Kapazität der Batterie konstant sind. Bei einer zweiten Variante wird die Ladezustandsanzeige durch den Zähler und einen Spannungsdiskriminator gesteuert, der eine sogenannte "low charge" Spannung der Batterie detektiert. Die Anzeige des Ladezustands erfolgt solange ebenfalls lediglich anhand der durch den Zähler gemessenen Zeit, bis die Batteriespannung auf die "low charge" Spannung abgesunken ist. Danach wird jedoch ein Zähler gestartet, der eine bestimmte Restbetriebszeit vorgibt, die in einer zweiten Anzeigeeinheit angezeigt wird. Bei fortgeschrittener Alterung der Batterie und/oder ausgeprägtem Memory-Effekt zeigt diese Anzeige bereits dann "Null" an, wenn das Gerät mit der noch vorhandenen Restladung eine gewisse Zeit weiterbetrieben werden könnte. Nachteilig ist außerdem, daß die Anzeige für den Ladungszustand zwischen einer ersten und der zweiten Anzeigeeinheit des Displays hin- und herspringen kann, wenn die Klemmenspannung eventuell nur kurzzeitig wegen einer momentan besonders großen Belastung des Akkumulators unter den unteren Schwellwert absinkt.

Dieser Effekt läßt sich folgendermaßen erklären: Nimmt die im Akkumulator gespeicherte Ladungsmenge ab, sinkt auch die Klemmenspannung des Akkumulators. Wenn der Verbraucher den Akkumulator allerdings stärker belastet als angenommen, d.h., wenn ein größerer Strom durch den Akkumulator fließt als sonst, sinkt dadurch die Klemmenspannung des Akkumulators entsprechend stärker ab als bei einem Strom durchschnittlicher Größe. Im Akkumulator selbst fällt eine Spannung ab, die dem Produkt aus dem Innenwiderstand des Akkumulators und dem gerade fließenden Strom entspricht. Daraus ergibt sich, daß ein Absinken der Klemmenspannung des Akkumulators nicht nur beim Abnehmen der gespeicherten Ladungsmenge sondern auch beobachtet werden kann, wenn der Strom ansteigt. Wird also allein die Klemmenspannung als Kriterium für die Kapazität des Akkumulators herangezogen, so wird auch dann auf einen entsprechend weit fortgeschrittenen Entladungszustand des Akkumulators geschlossen, wenn aufgrund eines vergleichsweise großen Stroms durch den Verbraucher eine entsprechende Erniedrigung der Klemmenspannung des Akkumulators hervorgerufen wird, obwohl in Wirklichkeit dessen Ladungszustand deutlich über einem "low-charge" Punkt liegt, der einer Entladung des Akkumulators auf beispielsweise 10% oder 20% seiner Nominalkapazität entspricht. Bei Normalbedingungen nimmt bei diesem Punkt die Klemmenspannung des Akkumulators den unteren Schwellwert an. Bei diesem Ladezustand des Akkumulators ist aber noch ein sicherer Betrieb des Verbrauchers möglich.

Aus der EP 0 248 461 A1 ist eine Vorrichtung zur Bestimmung des Ladezustands einer Batterie bekannt. Beim Entladen der Batterie durch einen Verbraucher und/oder beim Aufladen durch ein Ladegerät wird einem Rechner ein Wert zugeführt, der die nominale Ladezeit bzw. Entladezeit repräsentiert und in einem ersten und einem zweiten Anpaßmittel gespeichert wird. Der Rechner berechnet den Ladezustand der Batterie indem die abgelaufene Entlade- oder Ladezeit als Bruchteil der angepaßten Entlade- bzw. Ladezeit ausgedrückt und angezeigt wird. Ferner wird während des Entladens bzw. Ladens der tatsächliche Ladezustand der Batterie durch Detektoren bestimmt, die das Absinken der Batteriespannung auf eine Referenzspannung und das Erreichen des vollgeladenen Zustands der Batterie detektieren. Ergibt sich eine Differenz zwischen dem berechneten und dem detektierten Ladezustand, wird der berechnete Ladezustand korrigiert, und der in den Anpaßmitteln gespeicherte Wert aktualisiert, sodaß in einem nachfolgenden Entlade- und Ladezyklus der berechnete Ladezustand in besserer Übereinstimmung mit dem detektierten Ladezustand ist. Diese Vorrichtung dient zur fortlaufenden möglichst genauen Anzeige des jeweiligen Ladezustands und ist sehr aufwendig.

Aufgabe der vorliegenden Erfindung ist es dagegen, ein einfach realisierbares Verfahren zur Bestimmung des "low charge" Zustands eines Akkumulators anzugeben. In diesem Zustand ist der Akkumulator bis auf eine bestimmte Restladung entladen, die beispielsweise 10% oder 20% seiner Kapazität entspricht, und seine Klemmenspannung besitzt einen bestimmten Wert. In diesem Zustand des Akkumulators ist aber noch ein sicherer Betrieb des Verbrauchers möglich.

Die genannte Aufgabe wird durch die Merkmale der Patentansprüche 1 und 2 gelöst.

Vorteilhaft zeigt sich also bei der Ausgestaltung des Verfahrens nach Anspruch 1, daß durch die kombinierte Auswertung der Klemmenspannung des Akkumulators und dem aus der Betriebszeit des Verbrauchers ermittelten Ladezustand des Akkumulators eine hinsichtlich der Genauigkeit verbesserte Anzeige des "low charge" Zustands des Akkumulators möglich ist.

Wird nämlich bei einem ermittelten Ladezustand des Akkumulators, der oberhalb der bestimmten unteren Grenze liegt, festgestellt, daß die Klemmenspannung des Akkumulators den bestimmten unteren Schwellwert der Klemmenspannung des Akkumulators unterschreitet, so kann dies daran liegen, daß der Akkumulator momentan mit einem stärkeren Strom belastet wird. Dies bedeutet aber, daß der Ladezustand des Akkumulators den entsprechenden low charge Punkt des Akkumulators, aufgrund der Abnahme der gespeicherten Ladung noch nicht erreicht hat. In diesem Falle wird also das Unterschreiten des bestimmten unteren Schwellwertes der Klemmenspannung ignoriert. Der auf dem Display angezeigte Ladezustand wird dann also weiterhin von dem aufgrund der aufsummierten Betriebszeit des Akkumulators ermittelten Ladezustand des Akkumulators bestimmt.

Unterschreitet andererseits die Klemmenspannung des Akkumulators den bestimmten unteren Schwellwert der Klemmenspannung, wenn zugleich der aufgrund der aufsummierten Betriebszeit des Verbrauchers ermittelte Ladezustand des Akkumulators eine bestimmte untere Grenze erreicht hat, so kann vergleichsweise sicher darauf geschlossen werden, daß das Unterschreiten des unteren Schwellwertes der Klemmenspannung auf eine Abnahme der im Akkumulator gespeicherten Ladung zurückzuführen ist. In diesem Falle erfolgt eine Normierung der Anzeige des Display dahingehend, daß ein Ladezustand des Akkumulators angezeigt wird, der einer Klemmenspannung des Akkumulators entsprechend dem bestimmten unteren Schwellwert der Klemmenspannung aufgrund der abgenommenen Ladung im Akkumulator entspricht.

In vorteilhafter Weise kann bei der Ausgestaltung des Verfahrens nach Anspruch 2 das Absinken der Klemmenspannung des Akkumulators durch die Auswertung des Stromes erkannt werden, ob die im Akkumulator gespeicherte Ladung abgenommen hat oder ob das Absinken der Klemmenspannung auf einen größeren Strom zurückzuführen ist. Im ersteren Fall wird dann abgeleitet, daß der Ladezustand des Akkumulators den Wert erreicht hat, der der Klemmenspannung des Akkumulators entsprechend dem bestimmten unteren Schwellwert der Klemmenspannung des Akkumulators entspricht. In diesem Falle erfolgt eine Normierung der Anzeige des Displays dahingehend, daß dieser entsprechende Ladezustand auf dem Display angezeigt wird. Im anderen Fall wird der auf dem Display angezeigte Ladezustand weiterhin von dem aufgrund der aufsummierten Betriebszeit des Akkumulators ermittelten Ladezustand des Akkumulators bestimmt.

Vorteilhaft zeigt sich bei der Ausführungsform nach Anspruch 1 gegenüber der Ausführungsform nach Anspruch 2, daß auf eine Messung und Auswertung des Stroms zur Ableitung des Ladezustandes des Akkumulators verzichtet werden kann. Bei der Ausgestaltung des Verfahrens nach Anspruch 2 werden jedoch die tatsächlichen Verhältnisse noch besser berücksichtigt als bei der Ausgestaltung des Verfahrens nach Anspruch 1, so daß sich hier eine weiter verbesserte Genauigkeit der Anzeige des Ladezustands des Akkumulators ergibt.

Bei der Ausgestaltung des Verfahrens nach Anspruch 3 kann in vorteilhafter Weise eine Alterung des Akkumulators erkannt werden. Mit einem ersten Kriterium erfolgt dies, indem durch die Auswertung des Stroms der tatsächliche Einfluß des Innenwiderstands des Akkumulators erfaßt wird und dadurch durch die gleichzeitige Erfassung der Klemmenspannung das tatsächliche Erreichen des low charge Punkts sicher erkannt werden kann. Eine Alterung des Akkumulators liegt dann vor, wenn dieser tatsächliche low charge Punkt erreicht ist und der aufgrund der aufsummierten Betriebszeit ermittelte Ladezustand eine mehr oder weniger große Restkapazität aufweist. Bei einem zweiten Kriterium wird dabei ausgewertet, daß bei dem erfaßten low charge Punkt der entsprechende Ladezustand von dem aufgrund der aufsummierten Betriebszeit ermittelten Ladezustand abweicht und diese Abweichung erst nach einer Zeitdauer auftritt, bei der dies durch normale Alterung des Akkumulators zu erwarten ist. Bei einem dritten Kriterium wird ausgewertet, daß diese Abweichung mit einer bestimmten Häufigkeit und insbesondere mit einer bestimmten Regelmäßigkeit auftritt.

Mit dieser Vorgehensweise nach Anspruch 3 kann also unabhängig von der Anzeige eine bestimmte Alterung eines Akkumulators erkannt werden. Es ist jedoch auch möglich, diese Erkennung der Alterung in Verbindung mit einer geeigneten Anzeige des Ladezustands des Akkumulators vorzusehen.

Gemäß Anspruch 4 wird die Verschmutzung des Geräts, die eine Ursache für einen großen Laststrom sein kann und die obengenannte Abweichung begründen könnte, ausgewertet.

In vorteilhafter Weise wird bei dem Verfahren nach Anspruch 5 eine Anpassung der Erkennung des low charge Punkts an die sich mit der Zeit verändernde Kennlinie der Klemmenspannung des Akkumulators bei fortschreitender Entladung vorgenommen.

Bei der Ausgestaltung des Verfahrens nach Anspruch 6 wird dabei erkannt, wann eine Anpassung an die Veränderung der Kennlinie nicht mehr geeignet ist, die Gerätefunktion sicher aufrecht zu erhalten. In diesem Fall muß bei einer Wartung der Akkumulator getauscht werden. Wenn dem Benutzer dies durch eine Anzeige mitgeteilt wird, weiß er also, wann das Gerät in die Wartung muß.

Bei der Ausgestaltung des Verfahrens nach Anspruch 7 wird der Wartungsvorgang als solcher vereinfacht, weil der entsprechende Fehlerfall dann bei der Durchführung der Wartung schnell erkennbar ist, ohne das ganze Gerät einer Funktionsprüfung unterziehen zu müssen.

Ausführungsbeispiele der Erfindung sind in den Zeichnungen näher dargestellt. Es zeigen dabei im einzelnen:
- Fig. 1: ein aus dem Stand der Technik bekanntes Blockschaltbild,
- Fig. 2: ein bekanntes Blockschaltbild mit einem Motor als elektrischem Verbraucher,
- Fig. 3: ein Ausgangssignal des Pulsbreitenmodulators in Fig. 2, wenn die Drehzahl des Motors entsprechend einer fallenden Akkumulatorspannung verringert wird,
- Fig. 4: die Motordrehzahl bei Steuerung des Tastverhältnisses des Pulsbreitenmodulators entsprechend Fig. 3,
- Fig. 5: ein erstes Flußdiagramm für ein erfindungsgemäßes Verfahren,
- Fig. 6: ein zweites Flußdiagramm für ein erfindungsgemäßes Verfahren, und
- Fig. 7: ein Flußdiagramm, das Teil der Flußdiagramme der Figuren 5 und 6 ist.

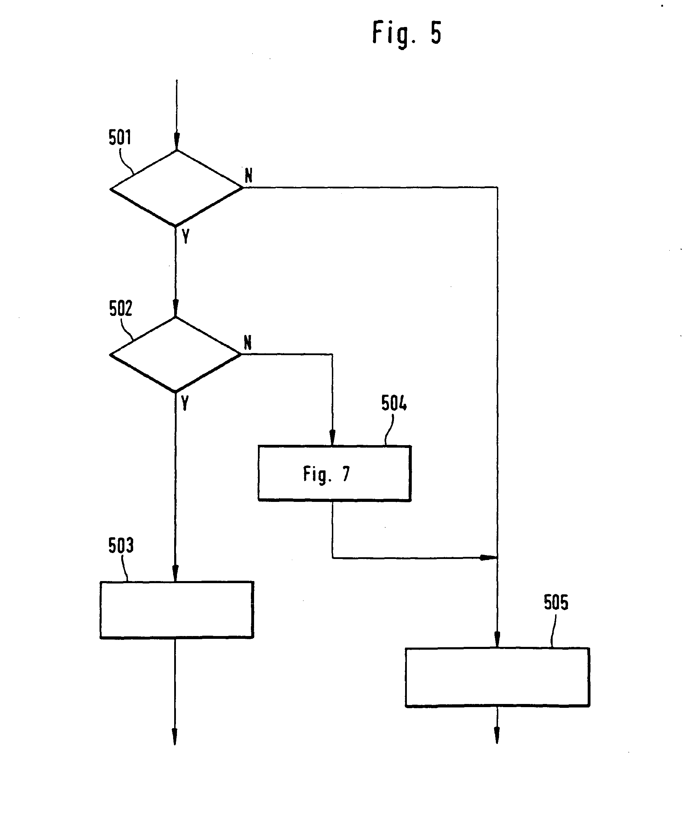

Fig. 5 zeigt den Teil des Ablaufs des erfindungsgemäßen Verfahrens, in dem überprüft wird, ob in dem Moment, in dem die Klemmenspannung des Akkumulators den bestimmten unteren Schwellwert unterschritten hat, tatsächlich der low-charge Punkt des Akkumulators erreicht ist. In dem Schritt 501 wird daher überprüft, ob die Klemmenspannung des Akkumulators den bestimmten unteren Schwellwert erreicht oder unterschritten hat.

Ist dies nicht der Fall, erfolgt ein Übergang zu dem Schritt 505, in dem die Anzeige des Displays entsprechend der von dem Zähler aufsummierten Betriebszeit des Verbrauchers gesteuert wird.

Wenn die Klemmenspannung des Akkumulators den bestimmten unteren Schwellwert unterschritten hat, erfolgt ein Übergang zu dem Schritt 502, in dem geprüft wird, ob der aufgrund der aufsummierten Betriebszeit ermittelte Ladezustand des Akkumulators eine bestimmte untere Grenze erreicht oder unterschritten hat. Wird der low-charge Punkt des Akkumulators beispielsweise auf 10% oder 20% Restkapazität des Akkumulators festgelegt, so kann der Wert dieser unteren Grenze beispielsweise einer Restkapazität des Akkumulators von 30% bis 40% entsprechen.

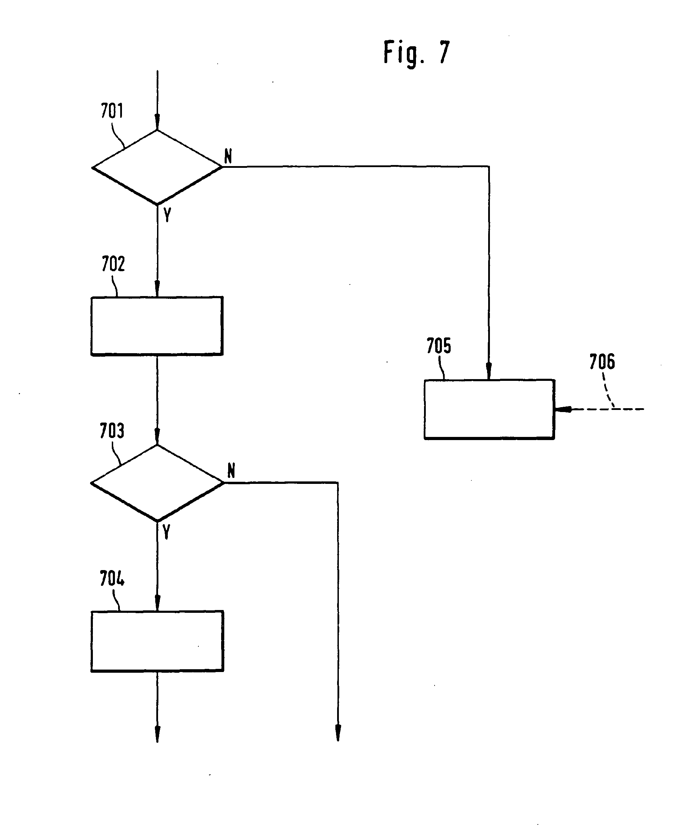

Wird die Überprüfung in dem Schritt 502 verneint, so kann daraus geschlossen werden, daß eine Betriebssituation abweichend von der normalen Betriebssituation vorliegt. Es ist möglich, dies auf bestimmte Betriebssituationen zurückzuführen, die dem Benutzer gegebenenfalls anzeigbar sind. Entsprechend dem Schritt 504 ist dies in der Fig.7 näher ausgeführt.

Entsprechend dem Schritt 505 wird der Ladezustand des Akkumulators auf dem Display weiterhin entsprechend dem Ladezustand angezeigt, der sich aufgrund der von dem Zähler aufsummierten Betriebszeit des Verbrauchers ergibt.

Wird die Überprüfung in dem Schritt 502 bejaht, so erfolgt ein Übergang zu dem Schritt 503, in dem die Anzeige des Display normiert wird derart, daß ein Ladezustand des Akkumulators angezeigt wird, der einer Klemmenspannung des Akkumulators entsprechend dem unteren Schwellwert der Klemmenspannung des Akkumulators bei normaler Belastung entspricht.

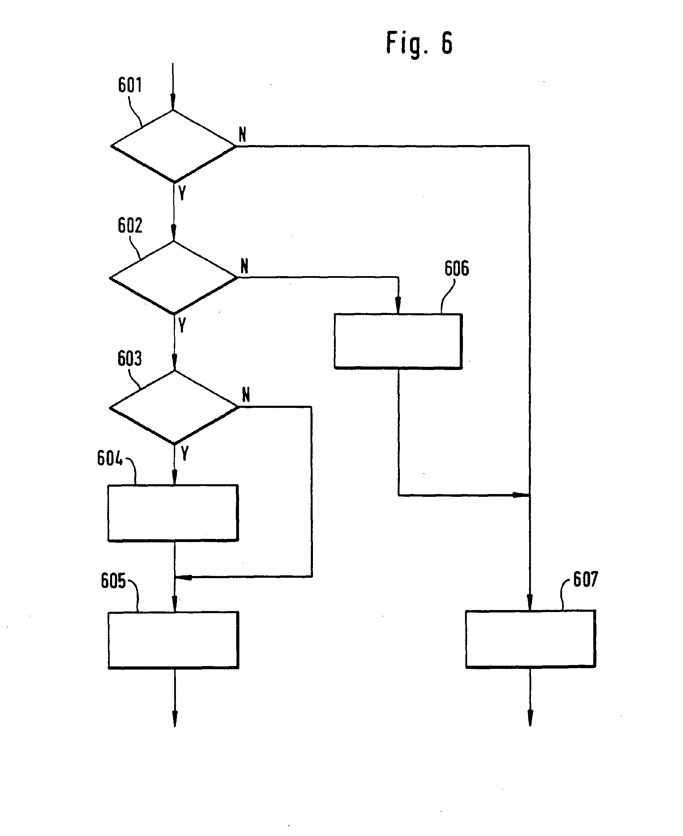

Fig. 6 zeigt eine alternative Ausgestaltung des Teiles des Ablaufes des erfindungsgemäßen Verfahrens, in dem überprüft wird, ob in dem Moment, in dem die Klemmenspannung des Akkumulators den bestimmten unteren Schwellwert unterschritten hat, tatsächlich der low-charge Punkt des Akkumulators erreicht ist. In dem Schritt 601 wird daher überprüft, ob die Klemmenspannung des Akkumulators den bestimmten unteren Schwellwert erreicht oder unterschritten hat.

Ist dies nicht der Fall, erfolgt ein Übergang zu dem Schritt 607, in dem die Anzeige des Display entsprechend der von dem Zähler aufsummierten Betriebszeit des Verbrauchers gesteuert wird.

Wenn die Klemmenspannung des Akkumulators den bestimmten unteren Schwellwert unterschritten hat, erfolgt ein Übergang zu dem Schritt 602, in dem geprüft wird, ob der bei eingeschaltetem Schalter fließende Strom einen bestimmten Grenzwert nicht überschreitet, der der Stromaufnahme des Verbrauchers unter normalen Betriebsbedingungen entspricht.

Wenn die Überprüfung in dem Schritt 602 bejaht wurde, d.h., wenn der Strom kleiner ist als dieser bestimmte Grenzwert, erfolgt in einer besonders vorteilhaften Ausgestaltung des Verfahrens nach Fig. 6 in dem Schritt 603 eine Überprüfung, ob der aufgrund der aufsummierten Betriebszeit ermittelte Ladezustand des Akkumulators eine bestimmte untere Grenze noch nicht erreicht oder unterschritten hat. Wird der low-charge Punkt des Akkumulators beispielsweise auf 10% oder 20% Restkapazität des Akkumulators festgelegt, so kann der Wert dieser unteren Grenze beispielsweise einer Restkapazität des Akkumulators von 30% bis 40% entsprechen.

Wenn bei der Überprüfung in dem Schritt 603 festgestellt wurde, daß der aufgrund der aufsummierten Betriebszeit ermittelte Ladezustand des Akkumulators die bestimmte untere Grenze noch nicht erreicht hat, so erklärt sich dies daraus, daß der Akkumulator gealtert ist. Dann hat sich die Kennlinie der Klemmenspannung des Akkumulators über der Zeit bei fortschreitender Entladung zu niedrigeren Werten der Spannung verschoben. Es ist dann möglich in dem Schritt 604 einen Verfahrensablauf nach Fig. 7 vorzusehen. Im Zusammenhang mit der Fig. 7 ist als mögliche Erklärung für diesen Betriebszustand ausgeführt, daß möglicherweise ein großer Laststrom fließt. Diese Erklärung der Fig. 7 gilt jedoch nur soweit als die Fig. 7 auf die Fig. 5 Bezug nimmt. Im Zusammenhang mit der Fig. 6 ist dieser Fall durch die Abfrage in dem Schritt 602 bereits ausgeschlossen. Deswegen könnte bei dem Einfügen der Fig.7 in den Schritt 604 die Überprüfung gemäß dem Schritt 701 eigentlich entfallen. Um aber bezüglich der Alterung des Akkumulators eine Fehlanzeige aufgrund einer einmalig auftretenden Abweichung des ermittelten Ladezustandes des Akkumulators von dem tatsächlichen Ladezustand des Akkumulators zu vermeiden, wird die Überprüfung nach dem Schritt 701 in vorteilhafter Weise auch bei dem Verfahrensablauf gemäß Fig. 6 vorgesehen.

Nach dem Schritt 604 sowie auch dann, wenn die Überprüfung in dem Schritt 603 verneint wurde, erfolgt ein Übergang zu dem Schritt 605, in dem die Anzeige des Display normiert wird derart, daß ein Ladezustand des Akkumulators angezeigt wird, der einer Klemmenspannung des Akkumulators entsprechend dem unteren Schwellwert der Klemmenspannung des Akkumulators bei normaler Belastung entspricht.

Es ist aber auch denkbar, die Überprüfung in dem Schritt 603 sowie den Schritt 604 entfallen zu lassen und im Falle, daß die Überprüfung in dem Schritt 602 bejaht wurde, direkt zu dem Schritt 605 überzugehen.

Wird die Überprüfung in dem Schritt 602 verneint, so fließt ein vergleichsweise großer Laststrom. Dies kann bei einem Elektrorasierer beispielsweise an relativ starken Barthaaren des Benutzers oder auch an einer relativ fortgeschrittenen Verschmutzung des Rasierers liegen. Entsprechend dem Schritt 606 kann in diesem Fall ein Signal erzeugt werden, das dem Benutzer beispielsweise eine Verschmutzung des Rasierers anzeigt. Da jedoch der Betriebszustand und dessen Ursache nicht eindeutig reproduzierbar sind, ist es ebenso denkbar, dieses Signal mit anderweitig gewonnen Signalen zu verknüpfen, um eine eindeutige Aussage zu bekommen und das Signal entsprechend dem Schritt 606 geeignet auszuwerten, beispielsweise durch Ansteuerung einer Anzeige oder einer geeigneten Anpassung der Motordrehzahl.

Entsprechend dem Schritt 607 wird der Ladezustand des Akkumulators auf dem Display weiterhin entsprechend dem Ladezustand angezeigt, der sich aufgrund der von dem Zähler aufsummierten Betriebszeit des Verbrauchers ergibt.

In vorteilhafter Weise sind dabei die Einheiten Festzeitzähler (5), Oszillator (6) und Pulsbreitenmodulator (4) Bestandteile eines Mikroprozessors. Dadurch ergibt sich auch eine einfache Form der Realisierung der Verfahren nach den Fig. 5 und 6. Ebenso kann dann in einfacher Weise der Ladezustand des Akkumulators aufgrund der Betriebszeit des Verbrauchers ermittelt werden, indem in dem Mikroprozessor die Betriebszeit aufsummiert.wird. In vorteilhafter Weise ist das Display in mehrere Segmente aufgeteilt, die einer bestimmten prozentualen Ladung des Akkumulators entsprechen. Die Ladung des Akkumulators kann dann über die einzelnen Segmente beispielsweise in Schritten von 20% der Ladung des Akkumulators angezeigt werden. Bei ermittelter fortschreitender Entladung des Akkumulators kommen dabei die entsprechenden Segmente des Display zur Anzeige. In vorteilhafter Weise sind weitere Elemente des Display vorgesehen, die in der beschriebenen Weise bei Erreichen des low-charge Zustandes Verwendung finden können. Es ist dabei auch denkbar, anstelle der Anzeige der verbleibenden Minuten der Benutzungszeit bis zur Abschaltung bei einem Rasierapparat anzuzeigen, wieviele Rasuren noch möglich sind. Dazu kann beispielsweise bei Verwendung des Mikroprozessors ausgewertet werden, wie lange eine durchschnittliche Rasur des Benutzers des Rasierapparates dauert. Anhand dieser durchschnittlichen Dauer einer Rasur kann dann eine Restbetriebszeit des Rasierapparates in eine verbleibende Anzahl von Rasuren umgerechnet werden.

Fig. 7 zeigt einen Teil des erfindungsgemäßen Verfahrens, der bei dem Blockschaltbild der Fig. 5 an der Stelle des Schrittes 504 und bei dem Blockschaltbild der Fig. 6 an der Stelle des Schrittes 604 eingefügt wird. An diesem Punkt des Verfahrensablaufes der Fig. 5 besteht die Situation, daß die Klemmenspannung des Akkumulators den bestimmten unteren Schwellwert erreicht oder unterschritten hat und daß aber der aufgrund der aufsummierten Betriebszeit ermittelte Ladezustand des Akkumulators die bestimmte untere Grenze noch nicht erreicht oder unterschritten hat.

Eine mögliche Ursache besteht darin, daß ein vergleichsweise großer Laststrom fließt. Dies kann bei einem Elektrorasierer beispielsweise an relativ starken Barthaaren des Benutzers oder auch an einer relativ fortgeschrittenen Verschmutzung des Rasierers liegen.

Eine weitere Erklärung besteht darin, daß der Akkumulator gealtert ist, so daß sich die Kennlinie der Akkumulatorspannung über der Zeit beim Entladen des Akkumulators zu niedrigeren Spannungswerten hin verschiebt. Dies bedeutet, daß eine Klemmenspannung des Akkumulators, die bei einem neuen Akkumulator bei Erreichen eines bestimmten unteren Schwellwertes der Klemmenspannung einem bestimmten entsprechend weit fortgeschrittenen Entladungszustand des Akkumulators entspricht, bei einem gealterten Akkumulator einer entsprechend größeren prozentualen Restkapazität des Akkumulators entspricht.

Eine Alterung des Akkumulators kann beispielsweise daran erkannt werden, daß in der Fig. 5 ein Übergang zu dem Schritt 504 bei der Benutzung des akkumulatorbetriebenen Gerätes erstmals nach mehreren Jahren Benutzung auftritt. Ebenso ist es auch denkbar, eine Alterung des Akkumulators dann abzuleiten, wenn ein Übergang zu dem Schritt 504, d.h. eine Bejahung der Überprüfung nach dem Schritt 501 und eine Verneinung der Überprüfung nach dem Schritt 502, bei der Entladung des Akkumulators und der jeweils zwischenzeitlichen Wiederaufladung des Akkumulators mehrmals auftritt, wobei dieses mehrmalige Auftreten insbesondere ein ununterbrochen aufeinanderfolgendes Auftreten sein kann. Es ist auch denkbar, dieses Kriterium des mehrmaligen Auftretens mit dem Kriterium des erstmaligen Auftretens nach mehreren Jahren der Benutzung des Geräts zu kombinieren. Liegt außerdem ein Signal vor, das einen bestimmten Verschmutzungsgrad des Gerätes repräsentiert, der insbesondere unabhängig von dem hier beschriebenen Verfahren erkannt wurde, so ist es denkbar, bei der Erkennung der Alterung des Akkumulators einen Übergang zu dem Schritt 504 nur dann zu berücksichtigen, wenn der Verschmutzungsgrad des Gerätes eine bestimmte Schwelle nicht überschreitet.

Bei dem Verfahrensablauf nach Fig. 6 ist dieser Fall durch die Abfrage in dem Schritt 602 eigentlich geklärt, da dort bereits der Strom ausgewertet wird. Deswegen könnte bei dem Einfügen der Fig. 7 in den Schritt 604 die Überprüfung gemäß dem Schritt 701 eigentlich entfallen. Um aber bezüglich der Alterung des Akkumulators eine Fehlanzeige aufgrund einer einmalig auftretenden Abweichung des ermittelten Ladezustandes des Akkumulators von dem tatsächlichen Ladezustand des Akkumulators zu vermeiden, wird die Überprüfung nach dem Schritt 701 in vorteilhafter Weise auch bei dem Verfahrensablauf gemäß Fig. 6 vorgesehen.

Der Alterung des Akkumulators kann dann beispielsweise dadurch Rechnung getragen werden, daß der bestimmte untere Schwellwert um einen bestimmten Betrag erniedrigt wird. Dieser Betrag kann dabei vorteilhaft in der Größenordnung von 40 bis 50mV liegen, wenn der bestimmte untere Schwellwert bei einem neuen Akkumulator bei 2,38V liegt. Dadurch läßt sich also für den weiteren Betrieb eine bessere Abstimmung zwischen dem aufgrund der Betriebszeit ermittelten Ladezustand des Akkumulators und dem aufgrund der Klemmenspannung abgeleiteten Ladezustand des Akkumulators erreichen. Da sich mit zunehmender Alterung des Akkumulators aber auch die einem an den Akkumulator angeschlossenen Verbraucher zur Verfügung stehende Kapazität des Akkumulators verringert, können zur Verbesserung des aufgrund der Betriebszeit ermittelten Ladezustandes die Zeitintervalle des Zählers sowie der Wert des Festzeitzählers entsprechend angepaßt werden.

Wenn dabei der bestimmte untere Schwellwert mit einer vorgegebenen Häufigkeit erniedrigt wurde, kann daraus geschlossen werden, daß die Alterung des Akkumulators so weit fortgeschritten ist, daß ein Austausch des Akkumulators notwendig ist. Diese vorgegebene Häufigkeit kann dabei nur eins betragen, d.h. daß der Akkumulator dann ausgetauscht werden muß, wenn nach einmaliger Erniedrigung des bestimmten unteren Schwellwertes immer noch ein Übergang zu dem Schritt 504 erfolgt; die vorgegebene Häufigkeit kann aber auch beispielsweise bei einer dreimaligen Erniedrigung des bestimmten unteren Schwellwertes liegen. Es ist dann möglich, die Alterung des Akkus zumindest indirekt dadurch anzuzeigen, daß ein Anzeigeelement angesteuert wird, das dem Benutzer signalisiert, daß der Rasierapparat zur Wartung muß. Bei dieser Wartung kann dann unter Umständen ein in dem Rasierapparat vorhandener Speicher ausgelesen werden, in dem eine Kennung eingetragen worden ist, daß ein defekter Akkumulator vorliegt. Aufgrund dieser Fehlerkennung ist es dann möglich, den Akkumulator ohne großen Aufwand bei der Fehlersuche als Fehlerquelle zu erkennen und auszutauschen bevor es zur Funktionsunfähigkeit des Rasierapparates kommt. Wenn der Rasierapparat geeignete Einrichtungen enthält, um andere Fehlerquellen zu erkennen, so können entsprechend der erkannten Fehlerquelle auch andere Fehlerkennungen in dem Speicher eingetragen werden. Wenn eine dieser Fehlerkennungen eingetragen wurde, wird dann ebenfalls das Anzeigelement angesteuert, das dem Benutzer signalisiert, daß das Gerät zur Wartung muß. Für den Benutzer ist also nur erkennbar, daß das Gerät zur Wartung muß. Bei der Wartung kann, dann durch Auswertung der jeweiligen Fehlerkennung der entsprechende Fehler schnell gefunden werden, ohne daß das Gerät einer langwierigen vollständigen Prüfung unterzogen werden muß.

Wird bei der Überprüfung erkannt, daß der Übergang zu dem Schritt 504 darauf zurückzuführen ist, daß ein relativ großer Laststrom fließt, so kann in diesem Fall ein Signal erzeugt werden, das dem Benutzer beispielsweise eine Verschmutzung des Rasierers anzeigt. Da jedoch der Betriebszustand und dessen Ursache nicht eindeutig reproduzierbar sind - es ist beispielsweise auch möglich, daß der Betriebszustand aufgrund stärkerer Barthaare auftritt -, ist es ebenso denkbar, dieses Signal mit anderweitig gewonnenen Signalen zu verknüpfen, um eine eindeutige Aussage zu bekommen und das Signal geeignet auszuwerten. Diese Auswertung kann beispielsweise in der Ansteuerung einer Anzeige oder einer geeigneten Anpassung der Motordrehzahl bestehen. Diese Anzeige signalisiert dem Benutzer beispielsweise, daß eine Pflege des Rasierers nötig ist, d.h., daß der Rasierer gereinigt werden muß.

Die Maßnahmen entsprechend den Erklärungen führen dann also zu folgendem Verfahrensablauf nach Fig. 7.

In dem Schritt 701 wird zunächst geprüft, ob eine Alterung des Akkumulators vorliegt. Diese Überprüfung kann dabei anhand wenigstens eines der Kriterien abgeleitet werden, ob der Übergang zu dem Schritt 504 erstmals nach mehreren Jahren der Benutzung des Gerätes auftritt, ob der Übergang zu dem Schritt 504 bei der Entladung des Akkumulators und der jeweils zwischenzeitlichen Wiederaufladung des Akkumulators mehrmals auftritt, wobei dieses mehrmalige Auftreten insbesondere ein ununterbrochen hintereinanderfolgendes Auftreten sein kann und/oder ob die Verschmutzung des Gerätes eine bestimmte Schwelle nicht überschreitet.

Wird die Überprüfung in dem Schritt 701 verneint, so erfolgt ein Übergang zu dem Schritt 705, in dem vorzugsweise entsprechend der Kombination mit einem weiteren Signal 706 dem Benutzer des Gerätes angezeigt werden kann, daß eine Pflege in Form einer Reinigung des Gerätes nötig ist, oder in dem die Motordrehzahl des Gerätes entsprechend angepaßt werden kann.

Wird die Überprüfung in dem Schritt 701 bejaht, so wird entsprechend dem Schritt 702 eine Erniedrigung des bestimmten unteren Schwellwertes vorgenommen, um der Alterung des Akkumulators Rechnung zu tragen.

In dem Schritt 703 wird dann geprüft, ob eine bestimmte Häufigkeit erreicht ist, mit der der bestimmte untere Schwellwert erniedrigt wurde. Dies kann insbesondere dadurch erfolgen, daß bei jedem Erniedrigen in dem Schritt 702 ein Zähler für dieses Erniedrigen inkrementiert wird, wobei in dem Schritt 703 dieser Zähler überprüft wird. Hat dieser Zähler einen bestimmten Wert, der insbesondere im Bereich von 2 bis 5 liegen kann, erreicht, so erfolgt ein Übergang zu dem Schritt 704.

In diesem Schritt 704 wird eine Fehlerkennung gesetzt, die eine fortschreitende Alterung des Akkumulators repräsentiert und bei der Wartung des Gerätes ausgelesen werden kann. Gleichzeitig wird eine Anzeige angesteuert, die dem Benutzer signalisiert, daß das Gerät gewartet werden muß.

Wurde bei der Überprüfung in dem Schritt 703 festgestellt, daß die bestimmte Häufigkeit noch nicht erreicht ist, wird der Verfahrensablauf der Fig. 7 beendet.

## Patentansprüche

1. Verfahren zur Bestimmung des Ladezustands eines Akkumulators in einem elektrischen Gerät
wobei bei dem Verfahren ab volladung des Akkumulators die Betriebszeit eines vom Akkumulator über einem Schalter speisbaren Verbrauchers mit im wesentlichen konstanten Stromverbrauch aufsummiert und daraus ein entsprechender Ladezustand des Akkumulators ermittelt und auf einem Display angezeigt wird, und ferner das Erreichen oder Unterschreiten (501) eines bestimmten unteren Schwellwerts der Klemmenspannung des Akkumulators ausgewertet wird, wobei der diesem Schwellwert der Klemmenspannung entsprechende Ladezustand des Akkumulators nur dann auf dem Display angezeigt wird (503), wenn der aufgrund der aufsummierten Betriebszeit ermittelte Ladezustand des Akkumulators eine bestimmte untere Grenze erreicht oder unterschritten hat (502).

2. verfahren zur Bestimmung des Ladezustands eines Akkumulators, in einem elektrischen Gerät
wobei bei dem Verfahren ab volladung des Akkumulators die Betriebszeit eines vom Akkumulator über einem Schalter speisbaren Verbrauchers mit im wesentlichen konstanten Stromverbrauch aufsummiert und daraus ein entsprechender Ladezustand des Akkumulators ermittelt und auf einem Display angezeigt wird,
und ferner das Erreichen oder Unterschreiten (601) eines bestimmten unteren Schwellwerts der Klemmenspannung des Akkumulators ausgewtert wird,
wobei der diesem Schwellwert der Klemmenspannung entsprechende Ladezustand des Akkumulators nur dann auf dem Display angezeigt wird (605), wenn der bei eingeschaltetem Schalter fließende Strom einen bestimmten Grenzwert nicht überschreitet, der der Stromaufnahme des Verbrauchers unter normalen Betriebsbedingungen entspricht (602).

3. Verfahren nach Anspruch 1 oder 2,
**dadurch gekennzeichnet,**
**daß** das Vorliegen einer Alterung des Akkumulators bei Erfüllung wenigstens eines der Folgenden Kriterien festgestellt wird (701):
wenn bei Erreichen ode des bestimmten unteren Schwellwerts der Klemmenspannung des Akkumulators der aufgrund der aufsummierten Betriebszeit ermittelte Lädezustand des Akkumulators die bestimmte untere Grenze weder erreicht noch unterschritten hat und der bei eingeschaltetem Schalter fließende Strom einen bestimmten Grenzwert nicht uberschreitet der der Stromaufnahme des Verbräuchers unter normalen Betriebsbedirigungen entspricht,
wenn der Zuständ daß bei Erreiclien oder Unterschreiten des bestimmten unteren Schwellwerts der klemmenspannung des Akkumulators der aufrung der aufsummierten Betriebszeit ermittelte Ladezustand des Akkumulators die bestimmte untere Grenze weder erreicht noch unterschritten hat, erstmsals nach mehreren Jahren Benutzung des Akkumulators auftritt, wenn der Zustand daß bei Erreichen oder Unterschreiten des bestimmten unteren der Klemmenspannung des Akkumulators der aufgrund der aufsummierten Betriebszeit, ermittelte Ladezustand des Akkumulators die bestimmte untere Grenze weder erreicht noch unterschritten hat, bei der Entladung des Akkumulators und der jeweils zwischenzeitlichen Wiederaufladung des Akkumulators mehrmals insbesondere mehrmals unmittelbar hintereianderfolgend, auftritt.

4. Verfahren nach Anspruch 3,
**dadurch gekennzeichnet,**
**daß** bei Anwendung des Verfahrens bei einem elektrischen Rasierapparats oder Haarschneidegerät das Vorliegen einer Alterung nur dann festgestellt wird, wenn in dem Gerät ein Signal vorliegt, das anzeigt, daß die Verschmutzung des Geräts eine bestimmte Schwelle nicht überschreitet

5. Verfahren nach Anspruch 3 oder 4,
**dadurchgekennzeichnet**,
daß bei Feststellung der Alterung des Akkumulators der bestimmte untere Schwellwert der Klemmenspannung um einen bestimmten Betrag erniedrigt wird (702).

6. Verfahren nach Anspruch 5,
**dadurch gekennzeichnet,**
**daß**, wenn nach einer bestimmten Häufigkeit der Erniedrigung des bestimmten unteren Schwellwerts der Klemmenspannung (702, 703), der Zustand, daß bei Erreichen oder Unterschreiten des dann gültigen. Werts des bestimmten unteren Schwellwerts der Klemünenspannung des Akkumulators der aufgrund der aufsummierten Betriebszeit ermittelte Ladezustand des Akkumulators eine bestimmte untere Grenze weder erreicht noch unterschritten hat, erneut uftritt eine Anzeige angesteuert wird, die signalisiert, daß das Gerät gewartet werden muß.

7. Verfahren nach Anspruch 5 oder 6,
**dadurch** gekennezeichnet,
daß, wenn nach einer betimmten Häufigkeit der Erniedrigung des bestimmten unteren Schwellwertes der Klemmenspannung: (702, 703), der Zustand, daß bei Erreichen oder Unterschreiten des dann gültigen Werts des bestimmten unteren Schwellwerts der Klemmenspannung des Akkumulators der aufgrund der aufsummierten Betriebszeit ermittelte Ladezustand des Akkumulators eine bestimmte untere Grenze weder erreicht hoch unterschritten hat, erneut auftritt in dem Gerät eine Fehlerkennung gesetzt wird, die die Alterung des Akkumulators repräsentiert und Durchführung der Wartung auslesbar ist.

## Claims

1. A method of determining the charge status of a storage battery in an electrical appliance,
said method comprising the steps of computing, from a fully charged condition of the storage battery, the cumulative operating time of a power-consuming device having a substantially constant power consumption and adapted to be fed by the storage battery via a switch, and determining therefrom a corresponding charge status of the storage battery and indicating it on a display,
and further analysing the reaching or falling below (501) of a predetermined lower threshold value of the terminal voltage of the storage battery,
wherein the charge status of the storage battery corresponding to said threshold value of the terminal voltage is indicated on the display (503) only when the charge status of the storage battery determined on the basis of the cumulative operating time has reached or fallen below a predetermined lower limit (502).

2. The method of determining the charge status of a storage battery in an electrical appliance, said method comprising the steps of computing, from a fully charged condition of the storage battery, the cumulative operating time of a power-consuming device having a substantially constant power consumption and adapted to be fed by the storage battery via a switch, and determining therefrom a corresponding charge status of the storage battery and indicating it on a display,
and further analysing the reaching or falling below (601) of a predetermined lower threshold value of the terminal voltage of the storage battery,
wherein the charge status of the storage battery corresponding to said threshold value of the terminal voltage is indicated on the display (605) only when the current flowing with the switch ON does not exceed a predetermined limit value that corresponds to the current consumption of the power-consuming device under normal operating conditions (602).

3. The method according to claim 1 or 2,
**characterized in that** the presence of aging of the storage battery is established if at least one of the following criteria is satisfied (701):
if, on the reaching or falling below of the predetermined lower threshold value of the terminal voltage of the storage battery, the charge status of the storage battery determined on the basis of the cumulative operating time has neither reached nor fallen below the predetermined lower limit and the current flowing with the switch ON does not exceed a predetermined limit value that corresponds to the current consumption of the power-consuming device under normal operating conditions;
if the condition that, on the reaching or falling below of the predetermined lower threshold value of the terminal voltage of the storage battery, the charge status of the storage battery determined on the basis of the cumulative operating time has neither reached nor fallen below the predetermined lower limit is not satisfied for the first time until after several years of using the storage battery;
if the condition that, on the reaching or falling below of the predetermined lower threshold value of the terminal voltage of the storage battery, the charge status of the storage battery determined on the basis of the cumulative operating time has neither reached nor fallen below the predetermined lower limit is satisfied repeatedly during discharge and each intermediate recharge of the storage battery, in particular in repeated, direct succession.

4. The method according to claim 3,
**characterized in that**, when applying the method to an electrical shaving or hair trimming device, the presence of aging is only established if the device provides a signal indicating that the soiling of the device does not exceed a predetermined threshold.

5. The method according to claim 3 or 4,
**characterized in that** in the event that aging of the storage battery is established, the predetermined lower threshold value of the terminal voltage is lowered by a specified amount (702).

6. The method according to claim 5,
**characterized in that** a readout signalling that the device has to be serviced is activated if, upon a preset frequency in the lowering of the predetermined lower threshold value of the terminal voltage (702, 703), the condition is again satisfied that, upon the terminal voltage of the storage battery reaching or falling below the then valid value of the predetermined lower threshold, the charge status of the storage battery determined on the basis of the cumulative operating time has neither reached nor fallen below a predetermined lower limit.

7. The method according to claim 5 or 6,
**characterized in that** a fault code indicative of the aging of the storage battery and readable during servicing is set in the device if, upon a preset frequency in the lowering of the predetermined lower threshold value of the terminal voltage (702, 703), the condition is again satisfied that, upon the terminal voltage of the storage battery reaching or falling below the then valid value of the predetermined lower threshold, the charge status of the storage battery determined on the basis of the cumulative operating time has neither reached nor fallen below a predetermined lower limit.

## Revendications

1. Procédé de détermination de l'état de charge d'un accumulateur dans un appareil électrique,
dans lequel, dans le procédé, à partir du chargement total de l'accumulateur, le temps de fonctionnement d'un consommateur pouvant être alimenté par l'accumulateur au moyen d'un commutateur avec une consommation de courant sensiblement constante est totalisé et on détermine à partir de là un état de charge correspondant de l'accumulateur et on l'affiche sur un afficheur
et en outre l'atteinte ou la non-atteinte (501) d'une certaine valeur seuil inférieure de la tension aux bornes de l'accumulateur est exploitée,
dans lequel l'état de charge de l'accumulateur correspondant à cette valeur seuil de la tension aux bornes ne s'affiche sur l'afficheur (503) que si l'état de charge de l'accumulateur déterminé à partir du temps de fonctionnement totalisé a atteint ou n'a pas atteint une certaine valeur inférieure (502).

2. Procédé de détermination de l'état de charge d'un accumulateur dans un appareil électrique,
dans lequel, dans le procédé, à partir du chargement total de l'accumulateur, le temps de fonctionnement d'un consommateur pouvant être alimenté par l'accumulateur au moyen d'un commutateur avec une consommation de courant sensiblement constante est totalisé et on détermine à partir de là un état de charge correspondant de l'accumulateur et on l'affiche sur un afficheur
et en outre l'atteinte ou la non-atteinte (601) d'une certaine valeur de seuil inférieure de la tension aux bornes de l'accumulateur est exploitée,
dans lequel l'état de charge de l'accumulateur correspondant à cette valeur seuil de la tension aux bornes ne s'affiche sur l'afficheur (605) que si le courant s'écoulant lorsque le commutateur est activé ne dépasse pas une certaine valeur limite qui équivaut à la consommation de courant du consommateur dans des conditions de fonctionnement normales (602).

3. Procédé selon la revendication 1 ou 2, **caractérisé en ce que**
la présence d'un vieillissement de l'accumulateur est constatée dans le cas où au moins des critères suivants est rempli (701) ;
si, en cas d'atteinte ou de non-atteinte de la certaine valeur inférieure de la tension aux bornes de l'accumulateur, l'état de charge déterminé à partir du temps de fonctionnement totalisé ni n'a atteint, ni n'est inférieur à la certaine limite inférieure et le courant s'écoulant lorsque le commutateur est activé ne dépasse pas une certaine valeur limite qui équivaut à la consommation en courant du consommateur dans des conditions de fonctionnement normales,
si l'état dans lequel, en cas d'atteinte ou de non-atteinte de la certaine valeur seuil inférieure de la tension aux bornes de l'accumulateur, l'état de charge de l'accumulateur déterminé à partir du temps de fonctionnement totalisé ni n'a atteint ni n'est inférieur à la certaine limite inférieure se produit pour la première fois après plusieurs années d'utilisation de l'accumulateur,
si l'état dans lequel, en cas d'atteinte ou de non-atteinte de la certaine valeur seuil inférieure de la tension aux bornes de l'accumulateur, l'état de charge de l'accumulateur déterminé à partir du temps de fonctionnement totalisé ni n'a atteint ni n'est inférieur à la certaine limite inférieure en cas de décharge de l'accumulateur et de recharge intermédiaire respective de l'accumulateur se produit plusieurs fois, notamment plusieurs fois en succession directe.

4. Procédé selon la revendication 3,
**caractérisé en ce que**,
en cas d'application du procédé dans un rasoir électrique ou une tondeuse à cheveux, la présence d'un vieillissement n'est constatée que s'il y a un signal indiquant que l'encrassement de l'appareil ne dépasse pas un certain seuil.

5. Procédé selon la revendication 3 ou 4,
**caractérisé en ce que**,
en cas de constatation du vieillissement de l'accumulateur, la certaine valeur seuil inférieure de la tension aux bornes est réduite d'une certaine valeur (702).

6. Procédé selon la revendication 5,
**caractérisé en ce que**,
si, après une certaine fréquence de la réduction de la certaine valeur seuil inférieure de la tension aux bornes (702, 703), l'état dans lequel, en cas d'atteinte ou de non-atteinte de la valeur alors valable de la certaine valeur seuil inférieure de la tension aux bornes de l'accumulateur, l'état de charge de l'accumulateur déterminé à partir du temps de fonctionnement totalisé ni n'a atteint ni n'est inférieur à une certaine limite inférieure se produit de nouveau, il est déclenché un affichage qui signale que l'appareil doit être entretenu.

7. Procédé selon la revendication 5 ou 6,
**caractérisé en ce que**,
si, après une certaine fréquence de la réduction de la certaine valeur seuil inférieure de la tension aux bornes (702, 703), l'état dans lequel, en cas d'atteinte ou de non-atteinte de la valeur alors valable de la certaine valeur seuil inférieure de la tension aux bornes de l'accumulateur, l'état de charge de l'accumulateur déterminé à partir du temps de fonctionnement totalisé ni n'a atteint ni n'est inférieur à une certaine limite inférieure, se produit de nouveau, il est placé dans l'appareil une détection d'erreur qui représente le vieillissement de l'accumulateur et est lisible lors de la réalisation de l'entretien.
